# EUROPEAN PATENT SPECIFICATION

(11) **EP 3 279 678 B1**
(45) Date of publication and mention of the grant of the patent: **22.11.2023**
(21) Application number: 16183045.0
(22) Date of filing: 05.08.2016
(51) Int. Cl.: G01R 31/367, G01R 31/374, G01R 31/3842, G01R 31/389, H01M 10/48, G01R 31/36

(54) **GAUGING METHOD FOR BATTERY DISCHARGE-CAPACITY CORRESPONDING TO TEMPERATURE AND ELECTRONIC DEVICE USING THE SAME**
VERFAHREN ZUR MESSUNG DER ENTLADEKAPAZITÄT EINER BATTERIE IN ABHÄNGIGKEIT VON DER TEMPERATUR UND ELEKTRONISCHES GERÄT, DAS DIESES VERFAHREN VERWENDET
PROCÉDÉ DE CALIBRAGE POUR LA CAPACITÉ DE DÉCHARGE DE BATTERIE CORRESPONDANT À LA TEMPÉRATURE ET DISPOSITIF ÉLECTRONIQUE L'UTILISANT

(43) Date of publication of application: 07.02.2018
(73) Proprietor: Getac Holdings Corporation, Taipei City 11568 (TW)
(72) Inventor: YU, Wen-Huan, Taipei City 11568 (TW)
(74) Representative: Viering, Jentschura & Partner mbB Patent- und Rechtsanwälte

(56) References cited:
- US-A- 6 157 169
- US-A1- 2006 164 042
- US-A1- 2012 166 116
- US-A1- 2014 103 933
- US-A1- 2015 025 823
- Ming Yu ET AL: "Theory and Implementation of Impedance Track(TM) Battery Fuel-Gauging Algorithm in bq20zxx Product Family", , 1 December 2006 (2006-12-01), XP055336672, Retrieved from the Internet: URL:http://www.ti.com/lit/an/slua364b/slua 364b.pdf [retrieved on 2017-01-18]
- POP V ET AL: "REVIEW ARTICLE; State-of-the-art of battery state-of-charge determination; Review Article", MEASUREMENT SCIENCE AND TECHNOLOGY, IOP, BRISTOL, GB, vol. 16, no. 12, 1 December 2005 (2005-12-01), pages R93-R110, XP020090492, ISSN: 0957-0233, DOI: 10.1088/0957-0233/16/12/R01

## Description

### BACKGROUND OF THE INVENTION

### FIELD OF THE INVENTION

The present invention relates to battery discharge-capacity management technology and, more particularly, to a gauging method for a battery discharge-capacity corresponding to a temperature and an electronic device using the same.

### DESCRIPTION OF THE PRIOR ART

Portable electronic devices, such as mobile phones, notebooks (NB), and personal digital assistants (PDA), come into wide use rapidly, because they are powered by battery modules and thus portable.

In practice, to meet voltage requirements, plenty application scenarios necessitate multiple series-connected unit batteries so as to effectuate a battery module operating at a required voltage. To enable the optimal performance of a battery module and extend the service life of the battery module, an electronic device is usually equipped with a battery management system for monitoring the battery module. The battery management system is useful in accessing state information pertaining to the battery module, providing overcharging/overdischarging protection, as well as equalizing battery voltage and/or estimating battery residual discharge-capacity. However, an unexpected insufficient power supply may cause the electronic device to shut down instantly and thus suffer a loss of data or get damaged. For the aforesaid reasons, recent years see the emergence of an important function of a battery module power supply system, that is, monitoring battery states in terms of temperature, voltage, current, residual capacitance state, and the like, to enable the optimal performance of battery modules.

According to prior art, a battery management system of an electronic device estimates a battery residual discharge-capacity with a gauging technique developed by Texas Instruments (TI). This gauging technique (also called TI gauging technique) is a known gauging technique/algorithm (also exemplarily called TI gauging technique/algorithm). However, at a low temperature, this known gauging technique (also called TI gauging technique) is obviously inaccurate and susceptible to erroneous judgements; as a result, the electronic device is likely to malfunction because of erroneous battery-related information.

Further, the application document US 2014/0103933 A1 provides a system and a method for estimating the capacity of a battery element in a vehicle. The system and the method only conduct estimations above a specific temperature threshold and, thus, they are not applicable for low temperatures. Besides, the patent application US 2015/0025823 A1 discloses a method and an apparatus configured to calculate the state of charge of a battery based on measured voltage, impedance, and temperature. Moreover, patent document US 006157169 A describes a method for calculating a remaining battery capacity from a detected battery voltage, wherein if at least one environmental factor causes an inaccuracy, a correction of the calculated remaining battery capacity is conducted based on the at least one environmental factor.

### SUMMARY OF THE INVENTION

The present invention provides a gauging method according to claim 1 and an electronic device according to claim 4. The dependent claims show further embodiments of said method and electronic device, respectively. In an embodiment, a gauging method for a battery discharge-capacity corresponding to a temperature, comprising the steps of: detecting a temperature of a battery module of the electronic device according to a predetermined condition; detecting the internal impedance of the battery module and estimating the battery discharge-capacity of the battery module according to the internal impedance if the temperature meets the predetermined condition; and detecting a voltage and an output current of the battery module and calculating the battery discharge-capacity of the battery module according to the temperature, the voltage and the output current if the temperature does not meet the predetermined condition.

In an embodiment, an electronic device for gauging a battery discharge-capacity corresponding to a temperature, comprising a battery module, a temperature sensing unit, a storing unit, and a processing unit. The processing unit is coupled to the battery module, the temperature sensing unit, and the storing unit. The battery module supplies power to the electronic device. The temperature sensing unit measures a temperature of the battery module. The storing unit stores a predetermined condition. The processing unit receives the temperature and confirms the received temperature according to the predetermined condition. If the temperature meets the predetermined condition, the processing unit will detect the internal impedance of the battery module and estimate the battery discharge-capacity of the battery module according to the internal impedance. If temperature does not meet the predetermined condition, the processing unit will detect a voltage and an output current of the battery module and calculate the battery discharge-capacity of the battery module according to the temperature, the voltage and the output current.

In conclusion, according to embodiments of the present invention, a gauging method for a battery discharge-capacity corresponding to a temperature and an electronic device using the same are characterized in that: the electronic device estimates a residual discharge-capacity of a battery module by a hybrid battery algorithm so that, at a low temperature, the residual discharge-capacity of the battery module is precisely estimated, so as to prevent the electronic device from malfunctioning because of erroneous battery-related information and/or prevent the electronic device from shutting down unexpectedly because of power supply interruptions.

### BRIEF DESCRIPTION OF THE DRAWINGS

FIG. 1 is a function block diagram of an electronic device for gauging a battery discharge-capacity corresponding to a temperature according to an embodiment of the present invention;
FIG. 2 is a flowchart of a gauging method for a battery discharge-capacity corresponding to a temperature according to an embodiment of the present invention;
FIG. 3 is a flowchart of the gauging method for a battery discharge-capacity corresponding to a temperature according to another embodiment of the present invention;
FIG. 4 is a schematic view of a corresponding data according to an embodiment of the present invention; and
FIG. 5 is a schematic view of a corresponding data according to another embodiment of the present invention.

### DETAILED DESCRIPTION OF THE EMBODIMENTS

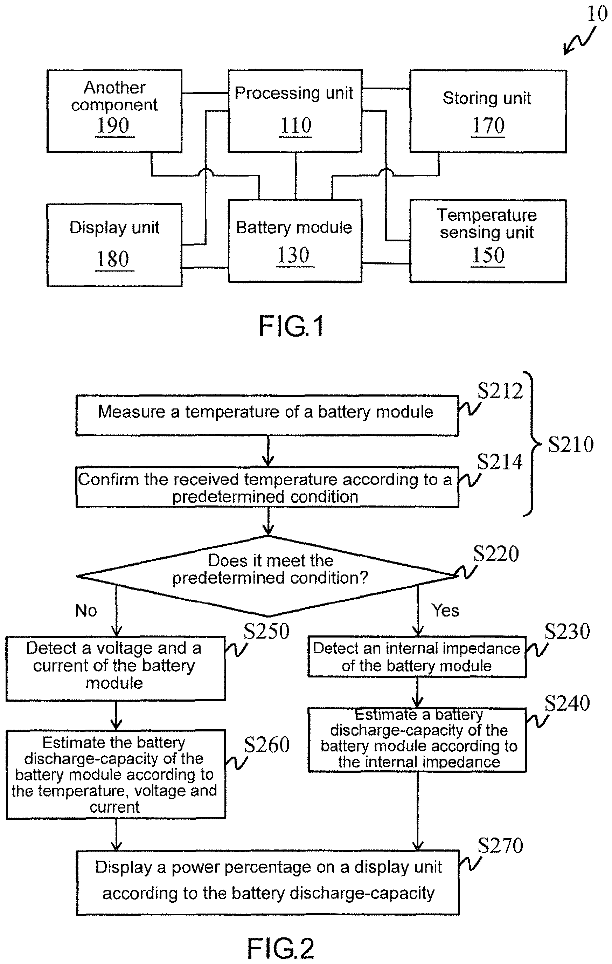

Referring to FIG. 1, an electronic device for gauging a battery discharge-capacity corresponding to a temperature (hereinafter abbreviated as "electronic device 10") comprises a processing unit 110, a battery module 130, a temperature sensing unit 150, a storing unit 170, and another component 190. The processing unit 110 is coupled to the battery module 130, the temperature sensing unit 150, the storing unit 170 and another component 190. The temperature sensing unit 150 is coupled to (in contact with) or positioned proximate to the battery module 130.

Referring to FIG. 2, the temperature sensing unit 150 is for measuring the temperature of the battery module 130 (step S212). The temperature of the battery module 130 is the temperature of the battery module 130 itself or the ambient temperature of the battery module 130.

The processing unit 110 receives the temperature measured by the temperature sensing unit 150 and confirms the received temperature according to a predetermined condition (step S214), so as to confirm whether the temperature of the battery module 130 meets the predetermined condition (step S220).

If the received temperature meets the predetermined condition, the processing unit 110 will detect the internal impedance of the battery module 130 (step S230) and estimate the battery discharge-capacity of the battery module 130 according to the detected internal impedance of the battery module 130, that is, the residual discharge-capacity (step S240). Conversely, if the received temperature does not meet the predetermined condition, the processing unit 110 will detect the output current and the voltage of the battery module 130 (step S250) and calculate the battery discharge-capacity of the battery module 130, that is, the residual discharge-capacity (step S260) according to the output current, the voltage, and the temperature of the battery module 130.

The predetermined condition is that the received temperature is higher than a temperature threshold. The processing unit 110 compares the received temperature with a temperature threshold. If the received temperature is higher than the temperature threshold, the processing unit 110 will determine that the received temperature meets the predetermined condition. Conversely, if the received temperature is lower than or equal to the temperature threshold, the processing unit 110 will determine that the received temperature does not meet the predetermined condition. In some embodiments, the temperature threshold is 0°C.

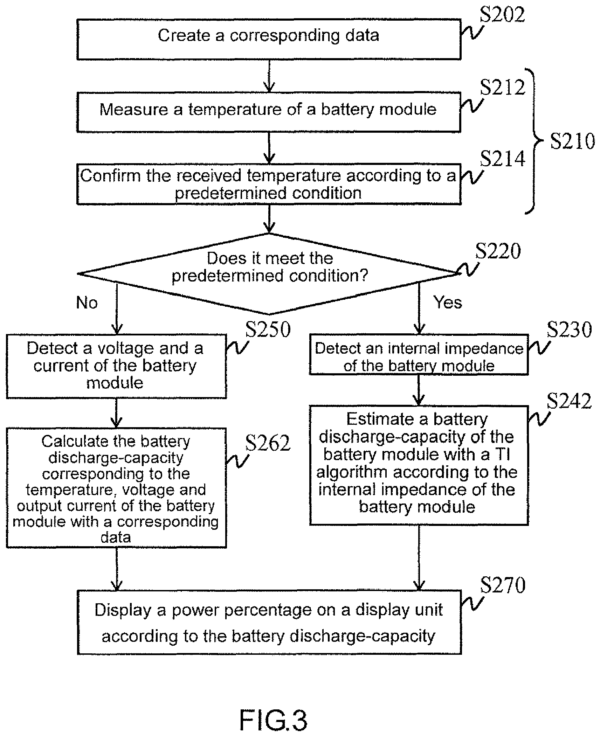

In some embodiments of step S240, the processing unit 110 estimates the battery discharge-capacity of the battery module 130 according to the internal impedance detected with an algorithm developed by Texas Instruments (TI) (step S242), as shown in FIG. 3.

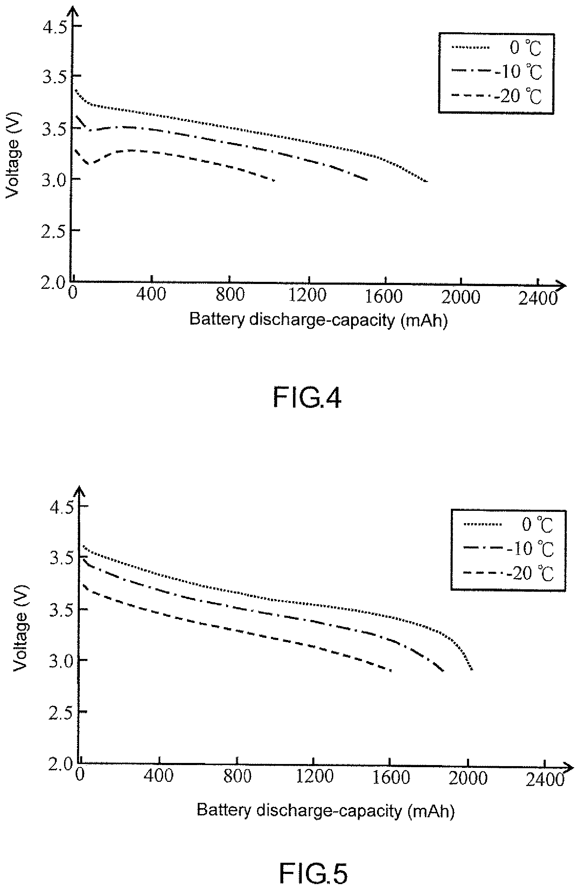

In step S260, the processing unit 110 calculates a battery discharge-capacity corresponding to the temperature, voltage and output current of the battery module 130 with a corresponding data (step S262), as shown in FIG. 3. The corresponding data is provided in the form of curves of voltage against battery discharge-capacity at different temperatures and different output currents, as shown in FIG. 4 and FIG. 5. Referring to FIG. 4, there are shown curves of voltage against battery discharge-capacity at different temperatures of the battery module 130 of a UF515161 SX lithium battery, with an output current of 2.1 00A. Referring to FIG. 5, there are shown curves of voltage against battery discharge-capacity at different temperatures of the battery module 130 of a UF515161SX lithium battery, with an output current of 0.420A.

In step S260, the processing unit 110 calculates a battery discharge-capacity with a corresponding data according to the temperature, voltage and output current of the battery module 130 by interpolation. For example, assuming that the corresponding data is provided in the form of curves of voltage against battery discharge-capacity at different temperatures and different output currents, the processing unit 110 selects a curve of voltage against battery discharge-capacity according to the temperature and output current of the battery module 130 and then use the voltage of the battery module 130 to obtain a preselected voltage and a preselected discharge-capacity which are correlated. Two preselected voltages approximate the voltage of the battery module 130. Afterward, the processing unit 110 performs interpolation on the preselected voltage and the preselected discharge-capacity, which are correlated, as well as the voltage of the battery module 130 to obtain the battery discharge-capacity which the voltage of the battery module 130 corresponds to.

Therefore, the processing unit 110 estimates the battery discharge-capacity of the battery module 130 with a known gauging technique (e.g. TI gauging technique) whenever the temperature meets the predetermined condition, and estimates the battery discharge-capacity of the battery module 130 with a corresponding low-temperature data whenever the temperature does not meet the predetermined condition.

The corresponding data is created by conducting a plurality of discharging tests on the battery module 130 and prestored in the storing unit 170 (step 202), as shown in FIG. 3.

Alternatively, the corresponding data is created by conducting a discharging test on a plurality of the battery modules with the same delivery condition as the battery module 130 and prestored in the storing unit 170 (step 202), as shown in FIG. 3.

In some embodiments, the electronic device 10 comprises a display unit 180. The display unit 180 is coupled to the processing unit 110. After calculating the battery discharge-capacity, the processing unit 110 displays a power percentage on the display unit 180 according to the calculated battery discharge-capacity (step S270) to inform the user of the residual discharge-capacity of the battery module 130. In some embodiments, the power percentage displayed on the display unit 180 comes in the form of a battery icon or digits. For instance, the processing unit 110 calculates the power percentage according to the calculated battery discharge-capacity and the full load of the battery module 130, and then the display unit 180 displays a corresponding battery icon or digits according to the calculated power percentage.

In some embodiments, after a temperature judgment (step S220), the processing unit 110 performs the detecting step, estimating step and displaying step (i.e., step S230, step S240 or S242 and step S270, or, alternatively, step S260, step S260 or S262 and step S270) repeatedly to discern and/or display the present residual discharge-capacity of the battery module 130.

In some embodiments, the processing unit 110 performs determining steps (i.e., step S210 and S220) anew at a predetermined time period to confirm the accepted way of estimating the battery discharge-capacity.

In some embodiments, the processing unit 110 is a microprocessor, a microcontroller, an embedded controller (EC) 30, a digital signal processor, a microcomputer, or a central processing unit (CPU).

In some embodiments, the battery module 130 stores power. The battery module 130 is coupled to power supply ends of components (for example, the processing unit 110, the temperature sensing unit 150, the storing unit 170 and another component 190) of the electronic device 10. The battery module 130 supplies stored power to components (for example, the processing unit 110, the temperature sensing unit 150, the storing unit 170 and another component 190) of the electronic device 10, while the electronic device 10 is operating. In some embodiments, the battery module 130 comprises one or more battery units.

In some embodiments, the storing unit 170 stores programs, parameters and data (for example, predetermined conditions, known algorithms (e.g. TI algorithms) and corresponding data) required for operation and stores temporarily parameters and data generated in the course of operation. The storing unit 170 is provided in the form of one or more memory devices. The memory devices are ready-only memory (ROM), random access memory (RAM), static memory, dynamic memory, flash memory, and/ or any equipment for storing digital information.

In some embodiments, another component 190 is required for assisting the electronic device 10 in performing functional operations. Take a notebook (NB) as an example, another component 190 is exemplified by a motherboard, a cooling fan, a display card, a sound card, a wireless chip, a hard disk drive, a display unit, a user interface, or any combination thereof, but the present invention is not limited thereto. In some embodiments, in addition to a notebook (NB), the electronic device 10 comes in the form of a tablet, a smartphone, a digital camera, an operating platform, a server, or a medical device.

The present invention further provides a gauging method for a battery discharge-capacity corresponding to a temperature. The gauging method for a battery discharge-capacity corresponding to a temperature comprises the steps of: detecting a temperature of a battery module of the electronic device according to a predetermined condition; detecting the internal impedance of the battery module and estimating the battery discharge-capacity of the battery module according to the internal impedance if the temperature meets the predetermined condition; and detecting a voltage and an output current of the battery module and calculating the battery discharge-capacity of the battery module according to the temperature, the voltage and the output current if the temperature does not meet the predetermined condition.

In some embodiments, according to the present invention, the gauging method for a battery discharge-capacity corresponding to a temperature is effectuated with a computer program product such that the gauging method for a battery discharge-capacity corresponding to a temperature is implemented according to any embodiment of the present invention by loading a program to an electronic device with a battery module and executing the program. In some embodiments, the computer program product is a computer-readable medium, whereas the program is stored in the computer-readable medium so as to be loaded to the electronic device. In some embodiments, the program is a computer program product and can be transmitted to the electronic device in a wired or wireless manner.

In conclusion, according to embodiments of the present invention, a gauging method for a battery discharge-capacity corresponding to a temperature and an electronic device using the same are characterized in that: the electronic device estimates a residual discharge-capacity of a battery module by a hybrid battery algorithm so that, at a low temperature, the residual discharge-capacity of the battery module is precisely estimated, so as to prevent the electronic device from malfunctioning because of erroneous battery-related information and/or prevent the electronic device from shutting down unexpectedly because of power supply interruptions.

## Claims

1. A gauging method for a battery discharge-capacity corresponding to a temperature, applicable to an electronic device (10), the gauging method comprising the steps of:
measuring (S212) the temperature of the battery module (130); and
comparing (S214) the temperature of the battery module 130 with a temperature threshold; and
if the temperature meets the temperature threshold, detecting (S230) the internal impedance of the battery module (130) and estimating (S240, S242) the battery discharge-capacity of the battery module (130) according to the internal impedance,
wherein the temperature meets the temperature threshold, when the temperature is higher than the temperature threshold;
wherein if the temperature does not meet the temperature threshold, detecting (S250) a voltage and an output current of the battery module (130) and calculating (S260, S262) the battery discharge-capacity of the battery module (130) according to the temperature, the voltage and the output current,
wherein the temperature does not meet the temperature threshold when the temperature is lower than or equal to the temperature threshold;
wherein:
the step of calculating (S260, S262) the battery discharge-capacity of the battery module (130) comprises calculating the battery discharge-capacity corresponding to the temperature, the voltage and the output current with corresponding data;
wherein the corresponding data is provided in the form of curves of voltage against battery discharge-capacity at different temperatures and different output currents;
wherein the gauging method for a battery discharge-capacity further comprises, before the step of detecting (S210) a temperature of a battery module (130) of the electronic device (10) according to the temperature threshold:
conducting a discharging test on a plurality of battery modules with the same delivery condition as the battery module (130) to create the corresponding data; or
conducting (S202) a plurality of discharging tests on the battery module (130) to create the corresponding data;
wherein the step of calculating (S260, S262) the battery discharge-capacity of the battery module (130) according to the temperature, the voltage and the output current comprises calculating the battery discharge-capacity with the corresponding data by interpolation.

2. The gauging method for a battery discharge-capacity corresponding to a temperature according to claim 1, wherein the step of estimating (S240, S242) the battery discharge-capacity of the battery module (130) according to the internal impedance comprises estimating the battery discharge-capacity of the battery module (130) with a known algorithm according to the internal impedance.

3. The gauging method for a battery discharge-capacity corresponding to a temperature according to claim 1, further comprising displaying (S270) a power percentage on a display unit (180) according to the battery discharge-capacity.

4. An electronic device (10) for gauging a battery discharge-capacity corresponding to a temperature, comprising:
a battery module (130) for suppling power to the electronic device (10);
a temperature sensing unit (150) for measuring a temperature of the battery module (130);
a storing unit (170) for storing a temperature threshold; and
a processing unit (110) coupled to the battery module (130), the temperature sensing unit (150), and the storing unit (170),
wherein the processing unit (110) is configured to receive the temperature measured by the sensing unit (150) and to confirm whether the received temperature meets the temperature threshold, wherein if the temperature meets the temperature threshold, the processing unit (110) is adapted to detect the internal impedance of the battery module (130) and to estimate the battery discharge-capacity of the battery module (130) according to the internal impedance, wherein the temperature meets the temperature threshold when the temperature is higher than the temperature threshold,
wherein, if the temperature does not meet the temperature threshold, the processing unit (110) is adapted to detect a voltage and an output current of the battery module (130) and to calculate the battery discharge-capacity of the battery module (130) according to the temperature, the voltage and the output current wherein the temperature does not meet the temperature threshold when the temperature is lower than or equal to the temperature threshold;
wherein:
the processing unit (110) calculates the battery discharge-capacity corresponding to the temperature, voltage and output current of the battery module (130) with corresponding data (step S262), wherein the corresponding data is provided in the form of curves of voltage against battery discharge-capacity at different temperatures and different output currents;
wherein the processing unit (110) calculates a battery discharge-capacity with a corresponding data according to the temperature, voltage and output current of the battery module (130) by interpolation;
wherein the corresponding data is created:
by conducting a plurality of discharging tests on the battery module (130) and prestored in the storing unit (170) (step 202); or
by conducting a discharging test on a plurality of the battery modules with the same delivery condition as the battery module (130) and prestored in the storing unit (170) (step 202).

5. The electronic device (10) for gauging a battery discharge-capacity corresponding to a temperature according to claim 4, wherein the storing unit (170) is further configured to store a known algorithm such that, when the temperature meets the temperature threshold, the processing unit (110) estimates the battery discharge-capacity of the battery module (130) with the known algorithm according to the internal impedance.

6. The electronic device (10) for gauging a battery discharge-capacity corresponding to a temperature according to claim 4, further comprising a display unit (180) coupled to the processing unit (110) to display a power percentage indicative of the battery discharge-capacity.

7. A computer program product comprising instructions which, when the computer program product is executed by the electronic device (10) according to claims 4-6, cause the electronic device (10) to gauge the battery discharge-capacity corresponding to the temperature.

8. The computer program product according to claim 7, wherein the computer program is transmitted to the electronic device (10) in a wired or wireless manner

9. A computer-readable medium having stored thereon the computer program product of claim 7.

## Patentansprüche

1. Messverfahren für eine Batterieentladekapazität, welches mit einer Temperatur korrespondiert und bei einer elektronischen Vorrichtung (10) anwendbar ist, wobei das Messverfahren die folgenden Schritte aufweist:
Messen (S212) der Temperatur des Batteriemoduls (130), und Vergleichen (S214) der Temperatur des Batteriemoduls (130) mit einem Temperaturschwellenwert, und
wenn die Temperatur den Temperaturschwellenwert erreicht, Detektieren (S230) der internen Impedanz des Batteriemoduls (130) und Schätzen (S240, S242) der Batterieentladekapazität des Batteriemoduls (130) gemäß der internen Impedanz,
wobei die Temperatur den Temperaturschwellenwert erreicht, wenn die Temperatur höher als der Temperaturschwellenwert ist,
wobei, wenn die Temperatur den Temperaturschwellenwert nicht erreicht, Detektieren (S250) einer Spannung und einer Ausgangsstromstärke des Batteriemoduls (130) und Berechnen (S260, S262) der Batterieentladekapazität des Batteriemoduls (130) gemäß der Temperatur, der Spannung und der Ausgangsstromstärke,
wobei die Temperatur den Temperaturschwellenwert nicht erreicht, wenn die Temperatur niedriger als oder gleich dem Temperaturschwellenwert ist,
wobei:
der Schritt des Berechnens (S260, S262) der Batterieentladekapazität des Batteriemoduls (130) das Berechnen der Batterieentladekapazität korrespondierend mit der Temperatur, der Spannung und der Ausgangsstromstärke mit korrespondierenden Daten aufweist,
wobei die korrespondierenden Daten in der Form von Spannung-Batterieentladekapazität-Kurven bei verschiedenen Temperaturen und verschiedenen Ausgangsstromstärken bereitgestellt werden,
wobei das Messverfahren für eine Batterieentladekapazität ferner, vor dem Schritt des Detektierens (S210) einer Temperatur eines Batteriemoduls (130) der elektronischen Vorrichtung (10) gemäß dem Temperaturschwellenwert, aufweist:
Durchführen eines Entladetests an einer Vielzahl von Batteriemodulen mit der gleichen Bereitstellungsbedingung wie das Batteriemodul (130), um die korrespondierenden Daten zu erzeugen, oder
Durchführen (S202) einer Vielzahl von Entladetests an dem Batteriemodul (130), um die korrespondierenden Daten zu erzeugen,
wobei der Schritt des Berechnens (S260, S262) der Batterieentladekapazität des Batteriemoduls (130) gemäß der Temperatur, der Spannung und der Ausgangsstromstärke das Berechnen der Batterieentladekapazität mit den korrespondierenden Daten mittels Interpolation aufweist.

2. Messverfahren für eine Batterieentladekapazität, welches mit einer Temperatur korrespondiert, gemäß Anspruch 1, wobei der Schritt des Schätzens (S240, S242) der Batterieentladekapazität des Batteriemoduls (130) gemäß der internen Impedanz das Schätzen der Batterieentladekapazität des Batteriemoduls (130) mit einem bekannten Algorithmus gemäß der internen Impedanz aufweist.

3. Messverfahren für eine Batterieentladekapazität, welches mit einer Temperatur korrespondiert, gemäß Anspruch 1, ferner aufweisend: Anzeigen (S270) eines Leistungsprozentsatzes auf einer Anzeigeeinheit (180) gemäß der Batterieentladekapazität.

4. Elektronische Vorrichtung (10) zum Messen einer Batterieentladekapazität korrespondierend mit einer Temperatur, aufweisend:
ein Batteriemodul (130) zum Versorgen der elektronischen Vorrichtung (10) mit Leistung,
eine Temperaturerfassungseinheit (150) zum Messen einer Temperatur des Batteriemoduls (130),
eine Speichereinheit (170) zum Speichern eines Temperaturschwellenwerts, und
eine Verarbeitungseinheit (110), welche mit dem Batteriemodul (130), der Temperaturerfassungseinheit (150) und der Speichereinheit (170) verbunden ist,
wobei die Verarbeitungseinheit (110) konfiguriert ist, um die Temperatur zu empfangen, welche mittels der Erfassungseinheit (150) gemessen wird, und um zu bestätigen, ob die empfangene Temperatur den Temperaturschwellenwert erreicht, wobei, wenn die Temperatur den Temperaturschwellenwert erreicht, die Verarbeitungseinheit (110) angepasst ist, um die interne Impedanz des Batteriemoduls (130) zu detektieren und die Batterieentladekapazität des Batteriemoduls (130) gemäß der internen Impedanz zu schätzen, wobei die Temperatur den Temperaturschwellenwert erreicht, wenn die Temperatur höher als der Temperaturschwellenwert ist,
wobei, wenn die Temperatur den Temperaturschwellenwert nicht erreicht, die Verarbeitungseinheit (110) angepasst ist, um eine Spannung und eine Ausgangsstromstärke des Batteriemoduls (130) zu detektieren und die Batterieentladekapazität des Batteriemoduls (130) gemäß der Temperatur, der Spannung und der Ausgangsstromstärke zu berechnen, wobei die Temperatur den Temperaturschwellenwert nicht erreicht, wenn die Temperatur geringer als oder gleich dem Temperaturschwellenwert ist,
wobei:
die Verarbeitungseinheit (110) die Batterieentladekapazität korrespondierend mit der Temperatur, der Spannung und der Ausgangsstromstärke des Batteriemoduls (130) mit korrespondierenden Daten berechnet (Schritt S262), wobei die korrespondierenden Daten in der Form von Spannung-Batterieentladekapazität-Kurven bei verschiedenen Temperaturen und verschiedenen Ausgangsstromstärken bereitgestellt sind,
wobei die Verarbeitungseinheit (110) eine Batterieentladekapazität mit korrespondierenden Daten gemäß der Temperatur, der Spannung und der Ausgangsstromstärke des Batteriemoduls (130) mittels Interpolation berechnet,
wobei die korrespondierenden Daten erzeugt werden:
mittels Durchführens einer Vielzahl von Entladetests an dem Batteriemodul (130) und in der Speichereinheit (170) vorgespeichert werden (Schritt 202), oder
mittels Durchführens eines Entladetests an einer Vielzahl von Batteriemodulen mit den gleichen Bereitstellungsbedingung wie das Batteriemodul (130) und in der Speichereinheit (170) vorgespeichert werden (Schritt 202).

5. Elektronische Vorrichtung (10) zum Messen einer Batterieentladekapazität korrespondierend mit einer Temperatur gemäß Anspruch 4, wobei die Speichereinheit (170) ferner konfiguriert ist, um einen bekannten Algorithmus zu speichern derart, dass, wenn die Temperatur den Temperaturschwellenwert erreicht, die Verarbeitungseinheit (110) die Batterieentladekapazität des Batteriemoduls (130) mit dem bekannten Algorithmus gemäß der internen Impedanz schätzt.

6. Elektronische Vorrichtung (10) zum Messen einer Batterieentladekapazität korrespondierend mit einer Temperatur gemäß Anspruch 4, ferner aufweisend: einer Anzeigeeinheit (180), welche mit der Verarbeitungseinheit (110) verbunden ist, um einen Leistungsprozentsatz anzuzeigen, welcher auf die Batterieentladekapazität hinweist.

7. Computerprogrammprodukt, aufweisend: Anweisungen, welche, wenn das Computerprogrammprodukt mittels der elektronischen Vorrichtung (10) gemäß den Ansprüchen 4 bis 6 ausgeführt wird, die elektronische Vorrichtung (10) dazu veranlassen, die Batterieentladekapazität zu messen, korrespondierend mit der Temperatur.

8. Computerprogrammprodukt gemäß Anspruch 7, wobei das Computerprogramm an die elektronische Vorrichtung (10) in einer drahtgebunden oder drahtlosen Weise übertragen wird.

9. Computerlesbares Medium, auf welchem das Computerprogrammprodukt gemäß Anspruch 7 gespeichert ist.

## Revendications

1. Procédé de jaugeage d'une capacité de décharge de batterie correspondant à une température, applicable à un dispositif électronique (10), le procédé de jaugeage comprenant les étapes de :
mesure (S212) de la température du module de batterie (130) ; et
comparaison (S214) de la température du module de batterie 130 à un seuil de température ; et
si la température atteint le seuil de température, la détection (S230) de l'impédance interne du module de batterie (130) et l'estimation (S240, S242) de la capacité de décharge de batterie du module de batterie (130) en fonction de l'impédance interne,
dans lequel la température atteint le seuil de température, lorsque la température est supérieure au seuil de température ;
dans lequel, si la température n'atteint pas le seuil de température, la détection (S250) d'une tension et d'un courant de sortie du module de batterie (130) et le calcul (S260, S262) de la capacité de décharge de batterie du module de batterie (130) en fonction de la température, de la tension et du courant de sortie,
dans lequel la température n'atteint pas le seuil de température lorsque la température est inférieure ou égale au seuil de température ;
dans lequel :
l'étape de calcul (S260, S262) de la capacité de décharge de batterie du module de batterie (130) comprend le calcul de la capacité de décharge de batterie correspondant à la température, à la tension et au courant de sortie avec des données correspondantes ;
dans lequel les données correspondantes sont fournies sous la forme de courbes de tension en fonction de la capacité de décharge de batterie à différentes températures et différents courants de sortie ;
dans lequel le procédé de jaugeage d'une capacité de décharge de batterie comprend en outre, avant l'étape de détection (S210) d'une température d'un module de batterie (130) du dispositif électronique (10) en fonction du seuil de température :
la réalisation d'un test de décharge sur une pluralité de modules de batterie ayant la même condition de fourniture que le module de batterie (130) pour créer les données correspondantes ; ou
la réalisation (S202) d'une pluralité de tests de décharge sur le module de batterie (130) pour créer les données correspondantes ;
où l'étape de calcul (S260, S262) de la capacité de décharge de batterie du module de batterie (130) en fonction de la température, de la tension et du courant de sortie comprend le calcul de la capacité de décharge de batterie avec des données correspondantes par interpolation.

2. Procédé de jaugeage d'une capacité de décharge de batterie correspondant à une température selon la revendication 1, dans lequel l'étape d'estimation (S240, S242) de la capacité de décharge de batterie du module de batterie (130) en fonction de l'impédance interne comprend l'estimation de la capacité de décharge de batterie du module de batterie (130) avec un algorithme connu en fonction de l'impédance interne.

3. Procédé de jaugeage d'une capacité de décharge de batterie correspondant à une température selon la revendication 1, comprenant en outre l'affichage (S270) d'un pourcentage de puissance sur une unité d'affichage (180) en fonction de la capacité de décharge de batterie.

4. Dispositif électronique (10) pour jauger une capacité de décharge de batterie correspondant à une température, comprenant :
un module de batterie (130) pour alimenter le dispositif électronique (10) en puissance ;
une unité de capture de température (150) pour mesurer une température du module de batterie (130) ;
une unité de stockage (170) pour stocker un seuil de température ; et
une unité de traitement (110) couplée au module de batterie (130), à l'unité de capture de température (150) et à l'unité de stockage (170),
dans lequel l'unité de traitement (110) est configurée pour recevoir la température mesurée par l'unité de capture (150) et pour confirmer si la température reçue atteint le seuil de température, dans lequel, si la température atteint le seuil de température, l'unité de traitement (110) est adaptée pour détecter l'impédance interne du module de batterie (130) et pour estimer la capacité de décharge de batterie du module de batterie (130) en fonction de l'impédance interne, dans lequel la température atteint le seuil de température lorsque la température supérieure au seuil de température,
dans lequel, si la température n'atteint pas le seuil de température, l'unité de traitement (110) est adaptée pour détecter une tension et un courant de sortie du module de batterie (130) et pour calculer la capacité de décharge de batterie du module de batterie (130) en fonction de la température, de la tension et du courant de sortie, dans lequel la température n'atteint pas le seuil de température lorsque la température est inférieure ou égale au seuil de température ;
dans lequel :
l'unité de traitement (110) calcule la capacité de décharge de batterie correspondant à la température, à la tension et au courant de sortie du module de batterie (130) avec des données correspondantes (étape S262), les données correspondantes étant fournies sous la forme de courbes de tension en fonction de la capacité de décharge de batterie à différentes températures et différents courants de sortie ;
dans lequel l'unité de traitement (110) calcule une capacité de décharge de batterie avec des données correspondantes en fonction de la température, de la tension et du courant de sortie du module de batterie (130) par interpolation ;
dans lequel les données correspondantes sont créées :
en effectuant une pluralité de tests de décharge sur le module de batterie (130) et préenregistrées dans l'unité de stockage (170) (étape 202) ; ou
en effectuant un test de décharge sur une pluralité des modules de batterie ayant la même condition de fourniture que le module de batterie (130) et stockées au préalable dans l'unité de stockage (170) (étape 202).

5. Dispositif électronique (10) de jaugeage d'une capacité de décharge de batterie correspondant à une température selon la revendication 4, dans lequel l'unité de stockage (170) est en outre configurée pour stocker un algorithme connu tel que, lorsque la température atteint le seuil de température, l'unité de traitement (110) estime la capacité de décharge de batterie du module de batterie (130) avec l'algorithme connu en fonction de l'impédance interne.

6. Dispositif électronique (10) de jaugeage d'une capacité de décharge de batterie correspondant à une température selon la revendication 4, comprenant en outre une unité d'affichage (180) couplée à l'unité de traitement (110) pour afficher un pourcentage de puissance indicatif de la capacité de décharge de batterie.

7. Produit programme d'ordinateur comprenant des instructions qui, lorsque le produit programme d'ordinateur est exécuté par le dispositif électronique (10) selon les revendications 4 à 6, amènent le dispositif électronique (10) à jauger la capacité de décharge de batterie correspondant à la température.

8. Produit programme d'ordinateur selon la revendication 7, dans lequel le programme d'ordinateur est transmis au dispositif électronique (10) d'une manière filaire ou sans fil.

9. Support lisible par ordinateur comprenant le produit programme d'ordinateur selon la revendication 7 stocké sur celui-ci.
